# EUROPEAN PATENT SPECIFICATION

(11) **EP 4 471 863 B1**
(45) Date of publication and mention of the grant of the patent: **12.08.2026**
(21) Application number: 22928925.1
(22) Date of filing: 09.12.2022
(51) Int. Cl.: H10F 39/00, H10F 39/15

(54) **SOLID-STATE IMAGING ELEMENT, AND METHOD FOR MANUFACTURING SOLID-STATE IMAGING ELEMENT**
FESTKÖRPERBILDGEBUNGSELEMENT UND VERFAHREN ZUR HERSTELLUNG EINES FESTKÖRPERBILDGEBUNGSELEMENTS
ÉLÉMENT D'IMAGERIE À SEMI-CONDUCTEURS ET PROCÉDÉ DE FABRICATION ASSOCIÉ

(30) Priority: 24.02.2022 JP 2022026501
(43) Date of publication of application: 04.12.2024
(73) Proprietor: Hamamatsu Photonics K.K., Hamamatsu-shi, Shizuoka 435-8558 (JP)
(72) Inventor: TAKAGI Shin-ichiro, Hamamatsu-shi, Shizuoka 435-8558 (JP); TANAKA, Fumiya, Hamamatsu-shi, Shizuoka 435-8558 (JP); YAMADA, Atsunori, Hamamatsu-shi, Shizuoka 435-8558 (JP); YONETA, Yasuhito, Hamamatsu-shi, Shizuoka 435-8558 (JP)
(74) Representative: Hoffmann Eitle
(86) International application number: PCT/JP2022/045534
(87) International publication number: WO 2023/162408

(56) References cited:
- JP-A- 2004 063 627
- JP-A- 2005 072 932
- JP-A- 2017 139 281
- JP-A- 2021 044 439
- JP-A- H0 324 759

## Description

### Technical Field

The present disclosure relates to a solid-state imaging element, and a method for manufacturing a solid-state imaging element.

### Background Art

Non Patent Literatures 1 and 2 describe a monolithic CCD-CMOS as a solid-state imaging element of the related art. The monolithic CCD-CMOS is a solid-state imaging element in which a CCD unit that generates charges in response to incidence of light and transfers the charges and a CMOS unit that processes a digital signal corresponding to the charges are formed on a single semiconductor substrate. Document JP 2017 139281 A shows a solid-state imaging element according to the prior-art.

### Citation List

### Non Patent Literature

Non Patent Literature 1: Lee, Hyun Jung. "Charge-Coupled CMOS TDI Imager." Proceedings of the 2017 International Image Sensor Workshop, Hiroshima, Japan. Vol. 30. 2017.

Non Patent Literature 2: De Moor, Piet, et al. "Enhanced time delay integration imaging using embedded CCD in CMOS technology." 2014 IEEE International Electron Devices Meeting. IEEE, 2014.

### Summary of Invention

### Technical Problem

In the monolithic CCD-CMOS described in Non Patent Literatures 1 and 2, in the CCD unit, a plurality of transfer electrodes are disposed in the same layer, and gaps are formed between adjacent transfer electrodes. Thus, there is a possibility that charges are trapped in a region corresponding to each gap in the semiconductor substrate, and transfer of charges is not appropriately performed. In addition, with downsizing of the monolithic CCD-CMOS, when a capacitance part and another circuit part are close to each other in the CMOS unit, parasitic capacitance may increase or crosstalk may occur between the capacitance part and another circuit part.

An object of the present disclosure is to provide a solid-state imaging element capable of securing high reliability, and a method for manufacturing such a solid-state imaging element.

### Solution to Problem

A solid-state imaging element according to an aspect of the present disclosure includes a semiconductor substrate, a first element unit formed on the semiconductor substrate, and a second element unit formed on the semiconductor substrate. The first element unit includes a light receiving part configured to generate charges in response to incidence of light, and a transfer part configured to transfer charges, the second element unit is configured to perform at least one of transmission of a signal to the first element unit and reception of a signal from the first element unit, and includes at least one capacitance part, the transfer part includes a first transfer electrode and a second transfer electrode that are aligned in a transfer direction of the charges, and a first insulating layer configured to insulate the first transfer electrode and the second transfer electrode from each other, the at least one capacitance part includes a first capacitance electrode and a second capacitance electrode that overlap each other as viewed from a thickness direction of the semiconductor substrate, and a second insulating layer configured to insulate the first capacitance electrode and the second capacitance electrode from each other, as viewed from the thickness direction of the semiconductor substrate, a part of the first transfer electrode overlaps a part of the second transfer electrode, the first insulating layer includes a first portion positioned between the part of the first transfer electrode and the part of the second transfer electrode, the second insulating layer includes a second portion positioned between the first capacitance electrode and the second capacitance electrode, and a thickness of the first portion of the first insulating layer is larger than a thickness of the second portion of the second insulating layer.

In the solid-state imaging element, the part of the first transfer electrode overlaps the part of the second transfer electrode as viewed from the thickness direction of the semiconductor substrate. As a result, it is less likely to form a gap between the first transfer electrode and the second transfer electrode as viewed from the thickness direction of the semiconductor substrate. Thus, in the transfer part, trapping of charges can be suppressed, and transfer of charges can be appropriately performed. In addition, in the solid-state imaging element, the thickness of the first portion of the first insulating layer is larger than the thickness of the second portion of the second insulating layer. As a result, the thickness of the insulating layer positioned between the first transfer electrode and the second transfer electrode can be increased, and the withstand voltage characteristics between the first transfer electrode and the second transfer electrode can be improved. As a result, a high voltage can be applied to the transfer part, and the saturation charge amount and the charge transfer efficiency in the transfer part can be improved. On the other hand, the thickness of the insulating layer positioned between the first capacitance electrode and the second capacitance electrode can be reduced, and downsizing of the capacitance part (downsizing of the mounting area) can be realized while maintaining a desired capacitance value. As a result, it is possible to increase the distance between the capacitance part and another circuit part, and it is possible to suppress an increase in parasitic capacitance or occurrence of crosstalk between the capacitance part and the other circuit part. Accordingly, according to the solid-state imaging element, high reliability can be secured.

In the solid-state imaging element according to the aspect of the present disclosure, the first insulating layer may be formed integrally with the second insulating layer. According to this configuration, high reliability can be secured with a simpler structure.

In the solid-state imaging element according to the aspect of the present disclosure, the thickness of the first portion of the first insulating layer may be twice or more the thickness of the second portion of the second insulating layer. According to this configuration, the withstand voltage characteristics between the first transfer electrode and the second transfer electrode can be further improved. Thus, a higher voltage can be applied to the transfer part, and the saturation charge amount and the charge transfer efficiency in the transfer part can be further improved.

In the solid-state imaging element according to the aspect of the present disclosure, the first element unit may include an amplifier part configured to convert the charge transferred by the transfer part into an analog signal, and the second element unit may include a conversion part configured to convert the analog signal into a digital signal. According to this configuration, the charge transferred by the transfer part can be converted into the digital signal that is not easily influenced by noise.

In the solid-state imaging element according to the aspect of the present disclosure, the second element unit may include a generation part configured to generate a drive signal for driving the first element unit. According to this configuration, since the drive signal for driving the first element unit can be generated inside the solid-state imaging element, the voltage value of the drive signal supplied from the outside of the solid-state imaging element to the first element unit can be reduced.

In the solid-state imaging element according to the aspect of the present disclosure, an operating voltage of the first element unit may be higher than an operating voltage of the second element unit. According to this configuration, the saturation charge amount and the charge transfer efficiency in the transfer part can be improved.

A method for manufacturing a solid-state imaging element according to another aspect of the present disclosure includes a step of preparing the semiconductor substrate, a step of forming the first transfer electrode and the first capacitance electrode on the semiconductor substrate, a step of forming the first insulating layer on at least the first transfer electrode and forming the second insulating layer on at least the first capacitance electrode, a step of adjusting a thickness of at least one of a portion of the first insulating layer positioned on the first transfer electrode and a portion of the second insulating layer positioned on the first capacitance electrode such that the thickness of the portion of the first insulating layer is larger than the thickness of the portion of the second insulating layer, and a step of forming the second transfer electrode and the second capacitance electrode on the semiconductor substrate.

According to the method for manufacturing a solid-state imaging element, the thickness of the portion of the first insulating layer positioned on the first transfer electrode is adjusted to be larger than the thickness of the portion of the second insulating layer positioned on the first capacitance electrode. As a result, in the manufactured solid-state imaging element, the thickness of the insulating layer positioned between the first transfer electrode and the second transfer electrode can be increased, and the withstand voltage characteristics between the first transfer electrode and the second transfer electrode can be improved. As a result, a high voltage can be applied to the transfer part, and the saturation charge amount and the charge transfer efficiency in the transfer part can be improved. On the other hand, the thickness of the insulating layer positioned between the first capacitance electrode and the second capacitance electrode can be reduced, and the downsizing of the capacitance part can be realized while maintaining a desired capacitance value. As a result, it is possible to increase the distance between the capacitance part and another circuit part, and it is possible to suppress an increase in parasitic capacitance or occurrence of crosstalk between the capacitance part and the other circuit part. Accordingly, according to the method for manufacturing a solid-state imaging element, it is possible to obtain the solid-state imaging element capable of securing high reliability.

In the method for manufacturing a solid-state imaging element according to the aspect of the present disclosure, in the step of forming the first insulating layer and forming the second insulating layer, the first insulating layer and the second insulating layer may be simultaneously and integrally formed. According to this configuration, since the first insulating layer and the second insulating layer are simultaneously and integrally formed, the manufacturing efficiency of the solid-state imaging element can be improved.

In the method for manufacturing the solid-state imaging element according to the aspect of the present disclosure, in the step of adjusting the thickness of the at least one of the portion of the first insulating layer and the portion of the second insulating layer, the thickness of the portion of the second insulating layer may be reduced by performing an etching process on the second insulating layer. According to this configuration, the thickness of the portion of the second insulating layer positioned on the first capacitance electrode can be more reliably reduced by the etching process.

In the method for manufacturing the solid-state imaging element according to the aspect of the present disclosure, in the step of adjusting the thickness of the at least one of the portion of the first insulating layer and the portion of the second insulating layer, the thickness of the portion of the first insulating layer may be increased by performing a film forming process on the first insulating layer. According to this configuration, the thickness of the portion of the first insulating layer positioned on the first transfer electrode can be more reliably increased by the film forming process.

### Advantageous Effects of Invention

According to the present disclosure, it is possible to provide the solid-state imaging element capable of securing high reliability, and the method of manufacturing such a solid-state imaging element.

### Brief Description of Drawings

FIG. 1 is a schematic plan view of a solid-state imaging element according to an embodiment.
FIG. 2 is a schematic sectional view of the solid-state imaging element in FIG. 1.
FIG. 3 is an enlarged view illustrating a detailed configuration of a first element unit and a second element unit.
FIG. 4 is a sectional view of the solid-state imaging element in FIG. 1.
FIG. 5 is a sectional view for describing a method for manufacturing the solid-state imaging element in FIG. 4.
FIG. 6 is a sectional view for describing the method for manufacturing the solid-state imaging element in FIG. 4.
FIG. 7 is a sectional view for describing the method for manufacturing the solid-state imaging element in FIG. 4.
FIG. 8 is a sectional view for describing the method for manufacturing the solid-state imaging element in FIG. 4.
FIG. 9 is a sectional view for describing the method for manufacturing the solid-state imaging element in FIG. 4.
FIG. 10 is a sectional view for describing the method for manufacturing the solid-state imaging element in FIG. 4.
FIG. 11 is a sectional view for describing the method for manufacturing the solid-state imaging element in FIG. 4.
FIG. 12 is a schematic plan view of a solid-state imaging element of a first modification.
FIG. 13 is a schematic plan view of a solid-state imaging element of a second modification.

### Description of Embodiments

Hereinafter, embodiments of the present disclosure will be described in detail with reference to the drawings. In the drawings, the same or corresponding portions are denoted by the same reference signs, and redundant portions are omitted.

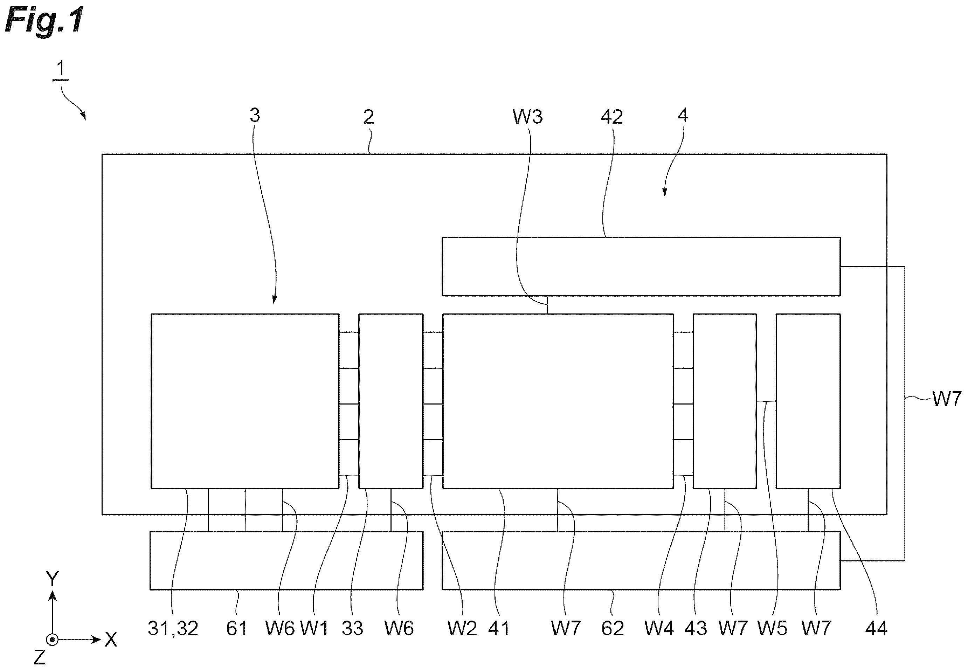

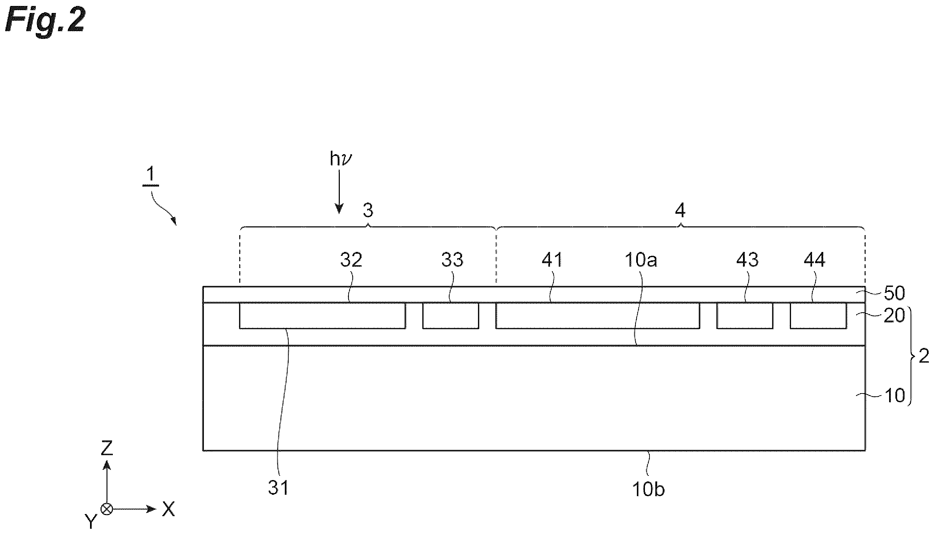

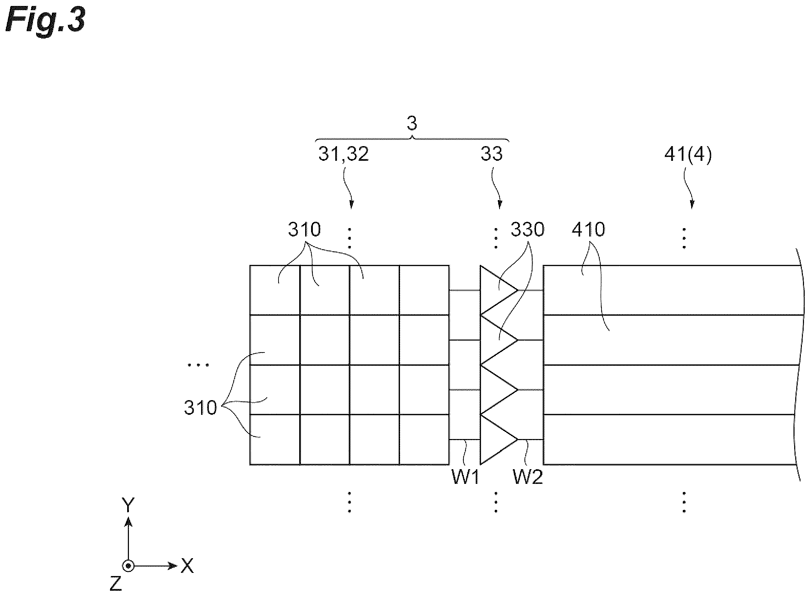

As illustrated in FIGS. 1 to 3, a solid-state imaging element 1 includes a semiconductor substrate 2, a first element unit 3, and a second element unit 4. The first element unit 3 and the second element unit 4 are formed on a single semiconductor substrate 2. The second element unit 4 is configured to receive a signal from the first element unit 3. The first element unit 3 is, for example, a charge coupled device (CCD) unit. The second element unit 4 is, for example, a complementary metal oxide semiconductor (CMOS) unit. That is, the solid-state imaging element 1 is, for example, a monolithic CCD-CMOS. Hereinafter, a thickness direction of the semiconductor substrate 2 is referred to as a Z direction, one direction perpendicular to the Z direction is referred to as an X direction, and a direction perpendicular to both directions of the Z direction and the X direction is referred to as a Y direction.

The semiconductor substrate 2 has, for example, a rectangular shape as viewed from the Z direction. A longitudinal direction of the semiconductor substrate 2 is along the X direction. The semiconductor substrate 2 includes a base portion 10 and a semiconductor layer 20 stacked in the Z direction.

The base portion 10 is a semiconductor substrate, and may be, for example, a silicon substrate. In the present embodiment, the base portion 10 has a P-type conductivity type. The base portion 10 is formed in a rectangular plate shape (rectangular parallelepiped shape). The base portion 10 has a pair of surfaces 10a and 10b perpendicular to the Z direction. A thickness of the base portion 10 is, for example, about 300 µm. The semiconductor layer 20 is formed on the surface 10a of the base portion 10. The semiconductor layer 20 is, for example, an epitaxial growth layer containing silicon. A thickness of the semiconductor layer 20 is, for example, about 10 µm.

The first element unit 3 includes a light receiving part 31, a transfer part 32, and an amplifier part 33. The light receiving part 31 generates charges in response to incidence of light hv. The light hv is incident on the light receiving part 31 from a wiring layer 50 side to be described later. The light receiving part 31 includes a plurality of pixels 310 aligned two-dimensionally along the X direction and the Y direction. The plurality of pixels 310 aligned along the X direction constitute a pixel array. The transfer part 32 transfers the charges generated in the light receiving part 31. The transfer part 32 transfers the charges along the X direction for each pixel array. The amplifier part 33 converts the charge transferred by the transfer part 32 into an analog signal (signal voltage). The amplifier part 33 includes a plurality of amplifiers 330. Each amplifier 330 is electrically connected to the corresponding pixel array via a wiring W1. The analog signal converted by the amplifier part 33 is transmitted to the second element unit 4.

The second element unit 4 includes a conversion part 41, a drive part 42, a multiplexer part 43, and an output part 44. The conversion part 41 converts the analog signal transmitted from the first element unit 3 into a digital signal. The conversion part 41 includes a plurality of analog-to-digital converters (ADCs) 410. The plurality of ADCs 410 are aligned in the Y direction. A pitch (distance between centers) between the ADCs 410 adjacent to each other in the Y direction is equal to a pitch between the pixels 310 adjacent to each other in the Y direction. The pitch between the ADCs 410 is, for example, about several µm to several tens µm. Each ADC 410 is electrically connected to the corresponding amplifier 330 via a wiring W2.

The drive part 42 generates a signal for driving the conversion part 41. The drive part 42 includes, for example, a phase locked loop (PLL) and a timing generator. The drive part 42 is electrically connected to the conversion part 41 via a wiring W3. The multiplexer part 43 bundles a plurality of digital signals converted by the conversion part 41 to generate one digital signal. The multiplexer part 43 is electrically connected to the conversion part 41 via a wiring W4. The output part 44 converts the digital signal from the multiplexer part 43 into a differential voltage signal and outputs the differential voltage signal to an outside. The output part 44 includes, for example, a low voltage differential signaling (LVDS) part. The output part 44 is electrically connected to the multiplexer part 43 via a wiring W5.

The first element unit 3 is electrically connected to a generation part 61 via a wiring W6. The generation part 61 generates a drive signal for driving the first element unit 3. The generation part 61 is formed outside the solid-state imaging element 1. The drive signal generated by the generation part 61 may be, for example, an operating voltage applied to the first element unit 3. The operating voltage includes, for example, a transfer voltage applied to the transfer part 32.

The second element unit 4 is electrically connected to a generation part 62 via a wiring W7. The generation part 62 generates a drive signal for driving the second element unit 4. The generation part 62 is formed outside the solid-state imaging element 1. The drive signal generated by the generation part 62 may be, for example, an operating voltage applied to the second element unit 4. The operating voltage of the first element unit 3 may be higher than the operating voltage of the second element unit 4. The operating voltage of the first element unit 3 may be, for example, about 10 V, and the operating voltage of the second element unit 4 may be, for example, about 3.3 V. The wiring layer 50 is formed on the semiconductor layer 20. The wiring layer 50 includes various wirings and electrodes included in the solid-state imaging element 1. The wirings W1, W2, W3, W4, W5, W6, and W7 may be formed in, for example, the wiring layer 50.

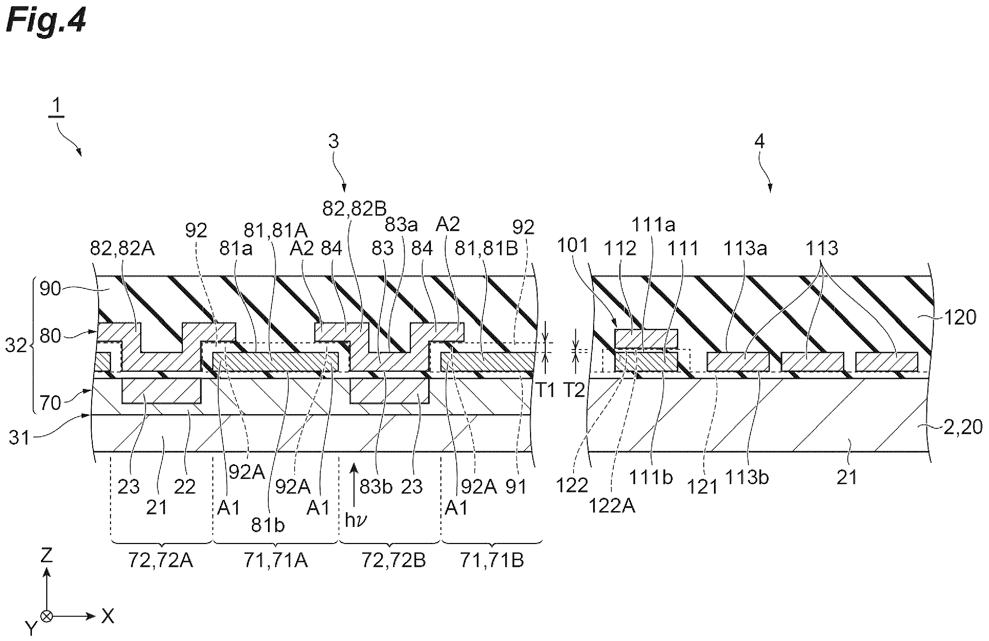

As illustrated in FIG. 4, the semiconductor layer 20 includes a semiconductor region 21. The semiconductor region 21 has a P-type conductivity type. A portion of the semiconductor layer 20 forming the first element unit 3 includes a semiconductor region 22 and a plurality of semiconductor regions 23. The semiconductor region 22 has an N-type conductivity type, and is formed on the semiconductor region 21. Each semiconductor region 23 has an N⁻-type conductivity type. The "N⁻-type" means that a concentration of an N-type impurity is lower than that of the "N-type". Each semiconductor region 23 is formed within the semiconductor region 22 along a surface of the semiconductor region 22 opposite to the semiconductor region 21.

The light receiving part 31 includes a PN junction region formed in the semiconductor layer 20. Specifically, the PN junction region is formed at a boundary portion between the semiconductor region 21 and the semiconductor region 22. When the light hv is incident on the PN junction region formed in the semiconductor layer 20, the charges are generated.

The transfer part 32 includes a charge transfer region 70, a plurality of transfer electrodes 80, and a plurality of insulating layers 90. The charge transfer region 70 is formed within the semiconductor layer 20. The charge transfer region 70 includes the semiconductor region 22 and the semiconductor region 23, and transfers the charge generated in the light receiving part 31. The charge transfer region 70 includes a plurality of first transfer regions 71 and a plurality of second transfer regions 72. The first transfer region 71 is a region of the semiconductor regions 22 positioned between two semiconductor regions 23 aligned in the X direction, and overlaps a first transfer electrode 81 to be described later in the Z direction. The first transfer region 71 does not include the semiconductor region 23. The second transfer region 72 is a region including the semiconductor region 23, and overlaps a second transfer electrode 82 to be described later in the Z direction. The first transfer region 71 and the second transfer region 72 are alternately aligned in a transfer direction of the charges (X direction). The semiconductor region 22 has an N-type conductivity type, and the semiconductor region 23 has an N⁻-type conductivity type. Accordingly, an impurity concentration of the first transfer region 71 is higher than an impurity concentration of the second transfer region 72.

The plurality of transfer electrodes 80 are disposed over the charge transfer region 70 and are aligned in the transfer direction of the charges (X direction). The plurality of transfer electrodes 80 includes a plurality of first transfer electrodes 81 and a plurality of second transfer electrodes 82. The first transfer electrode 81 and the second transfer electrode 82 transfer the charges generated in the light receiving part 31 in the X direction. The first transfer electrode 81 and the second transfer electrode 82 transfer the charges for each pixel array extending along the X direction. The first transfer electrode 81 is disposed over the first transfer region 71, and the second transfer electrode 82 is disposed over the second transfer region 72. The first transfer electrodes 81 and the second transfer electrodes 82 are alternately aligned in the X direction. The first transfer electrode 81 and the second transfer electrode 82 are made of, for example, polysilicon. The first transfer electrode 81 and the second transfer electrode 82 are electrically connected to the generation part 61 via, for example, a wiring formed in the wiring layer 50.

The first transfer electrode 81 has a flat plate shape along the X direction and the Y direction. The first transfer electrode 81 is positioned apart from the semiconductor layer 20. The first transfer electrode 81 has a pair of surfaces 81a and 81b opposed to each other in the Z direction. The surfaces 81a and 81b are along the X direction and the Y direction. The surface 81a is positioned farther from the semiconductor layer 20 than the surface 81b. As viewed from the Z direction, the first transfer electrode 81 has a pair of overlapping portions A1 overlapping a part (overlapping portion A2) of the second transfer electrode 82. The pair of overlapping portions A1 is both end portions of the first transfer electrode 81 in the X direction.

The second transfer electrode 82 includes a first portion 83 and a pair of second portions 84. The first portion 83 has a flat shape along the X direction and the Y direction. The first portion 83 is positioned apart from the semiconductor layer 20. The first portion 83 has a pair of surfaces 83a and 83b opposed to each other in the Z direction. The surfaces 83a and 83b are along the X direction and the Y direction. The surface 83a is positioned farther from the semiconductor layer 20 than the surface 83b. A distance from the semiconductor layer 20 to the surface 83b in the Z direction is the same as a distance from the semiconductor layer 20 to the surface 81b.

The second portion 84 is positioned farther from the semiconductor layer 20 than the first portion 83 in the Z direction. The second portion 84 is formed to be bent in XZ sectional view. The second portion 84 has a portion along the Y direction and the Z direction and a portion along the X direction and the Y direction. The portion of the second portions 84 along the Y direction and the Z direction are continuous with corresponding end portions of both end portions of the first portion 83 in the X direction. The second portion 84 has an overlapping portion A2. The overlapping portion A2 is a portion overlapping the overlapping portion A1 of the first transfer electrode 81 as viewed from the Z direction. The overlapping portion A2 is positioned on the surface 81a side of the first transfer electrode 81 in the Z direction. In the present embodiment, a gap is not formed between the first transfer electrode 81 and the second transfer electrode 82 as viewed from the Z direction.

The plurality of insulating layers 90 are formed on the semiconductor layer 20. The plurality of insulating layers 90 are stacked in the Z direction. Each insulating layer 90 is made of, for example, silicon oxide. The silicon oxide is, for example, SiO₂. In FIG. 4, only insulating layers 91 and 92 among the plurality of insulating layers 90 are indicated by broken lines for the sake of convenience in description. In the actual solid-state imaging element 1, the plurality of insulating layers 90 may be integrated to such an extent that boundaries between the insulating layers 90 cannot be visually recognized. The insulating layer 91 extends between the semiconductor layer 20 and the transfer electrode 80. A thickness of the insulating layer 91 is uniform, and a thickness of a portion of the insulating layer 91 between the semiconductor layer 20 and the first transfer electrode 81 is the same as a thickness of a portion between the semiconductor layer 20 and the second transfer electrode 82.

The insulating layer (first insulating layer) 92 is formed on the insulating layer 91. The insulating layer 92 extends continuously along the surface 81a of the first transfer electrode 81. The insulating layer 92 is positioned between the first transfer electrode 81 and the second transfer electrode 82, and insulates the first transfer electrode 81 and the second transfer electrode 82 from each other. The insulating layer 92 includes a first portion 92A positioned between the overlapping portion A1 of the first transfer electrode 81 and the overlapping portion A2 of the second transfer electrode 82.

The second element unit 4 includes a capacitance part 101. The capacitance part 101 may be included in, for example, the conversion part 41, the drive part 42, the multiplexer part 43, or the output part 44, or may be included in another circuit part included in the second element unit 4. The capacitance part 101 includes a first capacitance electrode 111, a second capacitance electrode 112, and an insulating layer 122, which will be described later. The capacitance part 101 is, for example, a poly-insulator-poly (PIP) capacitance.

The second element unit 4 includes a semiconductor layer 20, a first capacitance electrode 111, a second capacitance electrode 112, a plurality of electrodes 113, and a plurality of insulating layers 120. The first capacitance electrode 111 and the second capacitance electrode 112 are disposed on the semiconductor layer 20. The first capacitance electrode 111 and the second capacitance electrode 112 are made of, for example, polysilicon. The first transfer electrode 81 and the second transfer electrode 82 are electrically connected to the generation part 62 via, for example, a wiring formed in the wiring layer 50. The first capacitance electrode 111 and the second capacitance electrode 112 have flat plate shapes along the X direction and the Y direction. The first capacitance electrode 111 is positioned between the semiconductor layer 20 and the second capacitance electrode 112. As viewed from the Z direction, the first capacitance electrode 111 and the second capacitance electrode 112 overlap each other.

The first capacitance electrode 111 is positioned apart from the semiconductor layer 20. The first capacitance electrode 111 has a pair of surfaces 111a and 111b opposed to each other in the Z direction. The surfaces 111a and 111b are along the X direction and the Y direction. The surface 111a is positioned farther from the semiconductor layer 20 than the surface 111b.

The plurality of electrodes 113 are disposed on the semiconductor layer 20 and are aligned in the X direction. Each electrode 113 is made of, for example, polysilicon. Each electrode 113 is electrically connected to the generation part 62 via, for example, a wiring formed in the wiring layer 50. Each electrode 113 has a flat plate shape along the X direction and the Y direction. Each electrode 113 may be, for example, a gate electrode of a field effect transistor (FET). Each electrode 113 is positioned apart from the semiconductor layer 20. Each electrode 113 has a pair of surfaces 113a and 113b opposed to each other in the Z direction. The surfaces 113a and 113b are along the X direction and the Y direction. The surface 113a is positioned farther from the semiconductor layer 20 than the surface 113b. A distance from the semiconductor layer 20 to the surface 113b in the Z direction is the same as a distance from the semiconductor layer 20 to the surface 111b.

The plurality of insulating layers 120 are formed on the semiconductor layer 20. The plurality of insulating layers 120 are stacked in the Z direction. Each insulating layer 120 is made of, for example, silicon oxide. The silicon oxide is, for example, SiO₂. In FIG. 4, only insulating layers 121 and 122 among the plurality of insulating layers 120 are indicated by broken lines for the sake of convenience in description. In the actual solid-state imaging element 1, the plurality of insulating layers 120 may be integrated to such an extent that boundaries between the insulating layers 120 cannot be visually recognized. The insulating layer 121 extends between the semiconductor layer 20, the first capacitance electrode 111, and the electrode 113. A thickness of the insulating layer 121 is uniform, and a thickness of a portion of the insulating layer 121 between the semiconductor layer 20 and the first capacitance electrode 111 is the same as a thickness of a portion between the semiconductor layer 20 and the electrode 113. The insulating layer 121 is formed integrally with the insulating layer 91.

The insulating layer (second insulating layer) 122 is formed on the insulating layer 121. The insulating layer 122 extends continuously along the surface 111a of the first capacitance electrode 111. The insulating layer 122 is positioned between the first capacitance electrode 111 and the second capacitance electrode 112, and insulates the first capacitance electrode 111 and the second capacitance electrode 112 from each other. The insulating layer 122 is formed integrally with the insulating layer 92. The insulating layer 122 includes a second portion 122A positioned between the first capacitance electrode 111 and the second capacitance electrode 112.

A thickness T1 of the first portion 92A of the insulating layer 92 is larger than a thickness T2 of the second portion 122A of the insulating layer 122. That is, an interval between the overlapping portion A1 of the first transfer electrode 81 and the overlapping portion A2 of the second transfer electrode 82 is larger than an interval between the first capacitance electrode 111 and the second capacitance electrode 112. The thickness T1 may be twice or more or five times or more the thickness T2. The thickness T1 may be, for example, 10 nm or more and 100 nm or less. The thickness T2 may be, for example, 5 nm or more and 20 nm or less.

An example of an operation of the solid-state imaging element 1 having the above configuration will be described. In the solid-state imaging element 1, when the light hv is incident on the light receiving part 31, the charges are generated in each pixel 310 of the light receiving part 31. The charges are transferred to the amplifier part 33 by the transfer part 32. Here, the transfer method of the charges will be described with reference to FIG. 4. In the present embodiment, a two-phase driving method is used as the charge transfer method. In the following description, the first transfer regions 71 illustrated in FIG. 4 are referred to as first transfer regions 71A and 71B, and the second transfer regions 72 are referred to as second transfer regions 72A and 72B. The first transfer electrode 81 over the first transfer region 71A is referred to as the first transfer electrode 81A, and the first transfer electrode 81 over the first transfer region 71B is referred to as the first transfer electrode 81B. Similarly, the second transfer electrode 82 over the second transfer region 72A is referred to as the second transfer electrode 82A, and the second transfer electrode 82 over the second transfer region 72B is referred to as the second transfer electrode 82B.

First, values of voltages (hereinafter, referred to as voltages P1.) applied to the first transfer electrode 81A and the second transfer electrode 82A are increased to appropriate values (for example, about 5 V). The first transfer region 71A has an impurity concentration higher than that of the second transfer region 72A. Thus, in a state where the voltages P1 having the same magnitude are applied to the first transfer electrode 81A and the second transfer electrode 82A, a potential well formed under the first transfer electrode 81A is deeper than a potential well formed under the second transfer electrode 82A. Due to this potential difference, the charges generated in the light receiving part 31 flow from the second transfer region 72A into the first transfer region 71A and are stored in the first transfer region 71A.

Subsequently, while the values of the voltages P1 applied to the first transfer electrode 81A and the second transfer electrode 82A are decreased, values of voltages (hereinafter, referred to as voltages P2.) applied to the first transfer electrode 81B and the second transfer electrode 82B are increased to appropriate values (for example, about 5 V). As a result, potential wells under the first transfer electrode 81B and the second transfer electrode 82B become deeper than the potential well under the first transfer electrode 81A. In the present embodiment, since the first transfer region 71B has an impurity concentration higher than that of the second transfer region 72B, the potential well under the first transfer electrode 81B is deeper than the potential well under the second transfer electrode 82B. Accordingly, in a state where the value of the voltage P2 is higher than the value of the voltage P1, the potential well gradually becomes deeper from the first transfer region 71A toward the first transfer region 71B. As a result, the charges stored in the first transfer region 71A pass through the second transfer region 72B and are transferred to the first transfer region 71B. Hereinafter, the charges are transferred in the X direction by repeating the above transfer method also in the other first transfer electrodes 81 and second transfer electrodes 82.

The charges transferred by the first transfer electrode 81 and the second transfer electrode 82 are sent to the amplifier part 33. In the present embodiment, a charge is sent to the amplifier 330 for each pixel array extending along the X direction. The electric charge is converted into an analog signal in the amplifier part 33. The analog signal converted by the amplifier part 33 is converted into a digital signal by the conversion part 41. The plurality of digital signals converted by the conversion part 41 are bundled in the multiplexer part 43 and are generated as one digital signal. This digital signal is converted into a differential voltage signal in the output part 44 and is output to the outside.

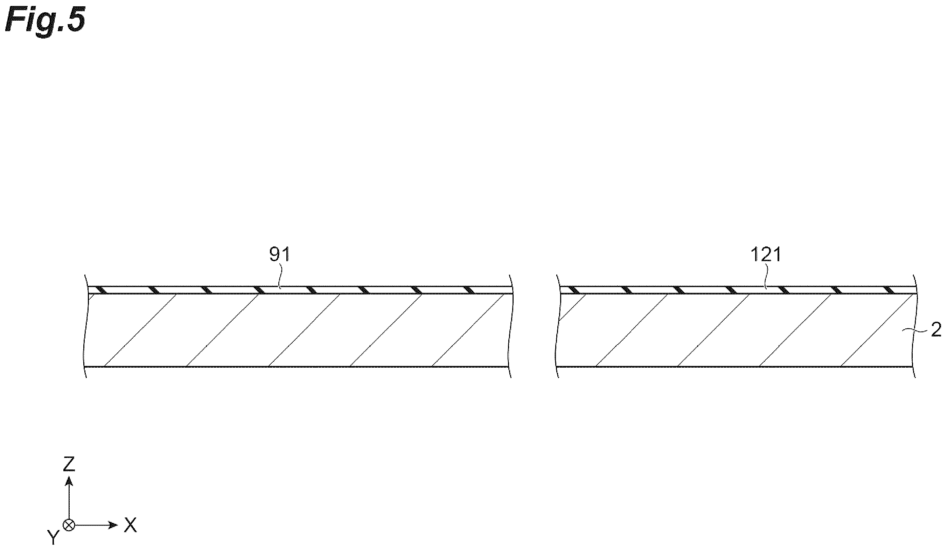

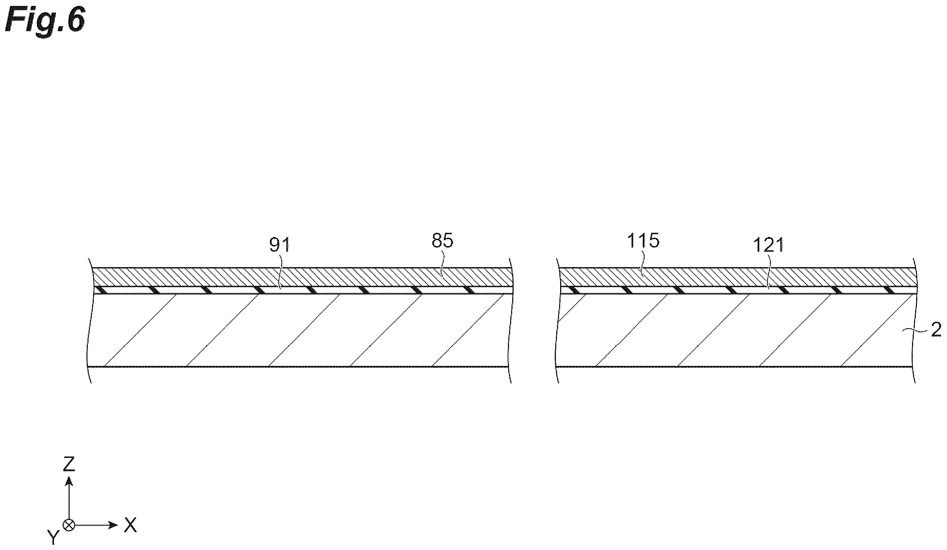

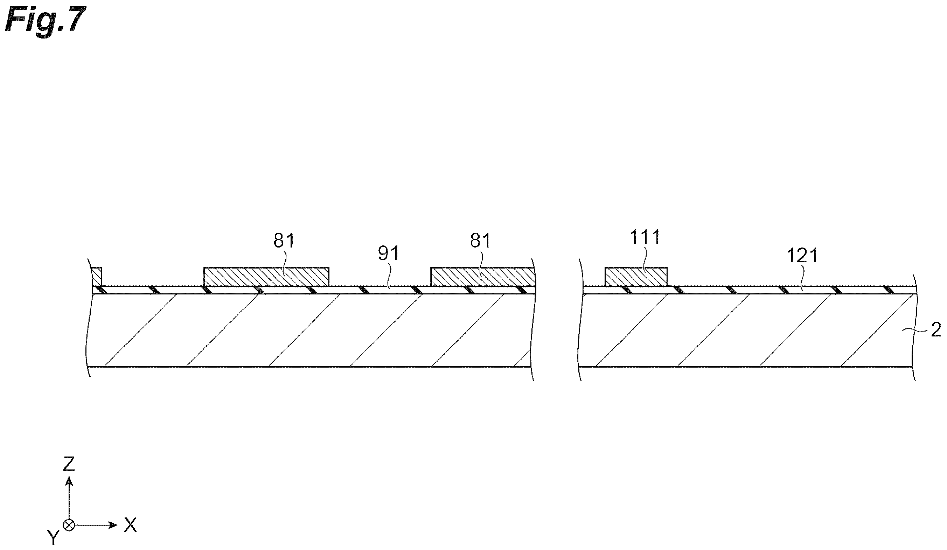

A method for manufacturing the solid-state imaging element 1 will be described with reference to FIGS. 5 to 11. First, as illustrated in FIG. 5, the semiconductor substrate 2 is prepared. Subsequently, a film forming process is performed on the semiconductor substrate 2, and thus, the insulating layer 91 and the insulating layer 121 are formed on a surface of the semiconductor substrate 2. The insulating layer 91 and the insulating layer 121 are simultaneously and integrally formed. Subsequently, as illustrated in FIG. 6, an electrode layer 85 is formed on a surface of the insulating layer 91, and an electrode layer 115 is formed on a surface of the insulating layer 121. The electrode layer 85 is made of a material of the first transfer electrode 81, and the electrode layer 115 is made of a material of the first capacitance electrode 111. The electrode layer 85 and the electrode layer 115 are simultaneously and integrally formed. Subsequently, as illustrated in FIG. 7, an etching process is performed on the electrode layer 85 and the electrode layer 115, and thus, the first transfer electrode 81 and the first capacitance electrode 111 are formed.

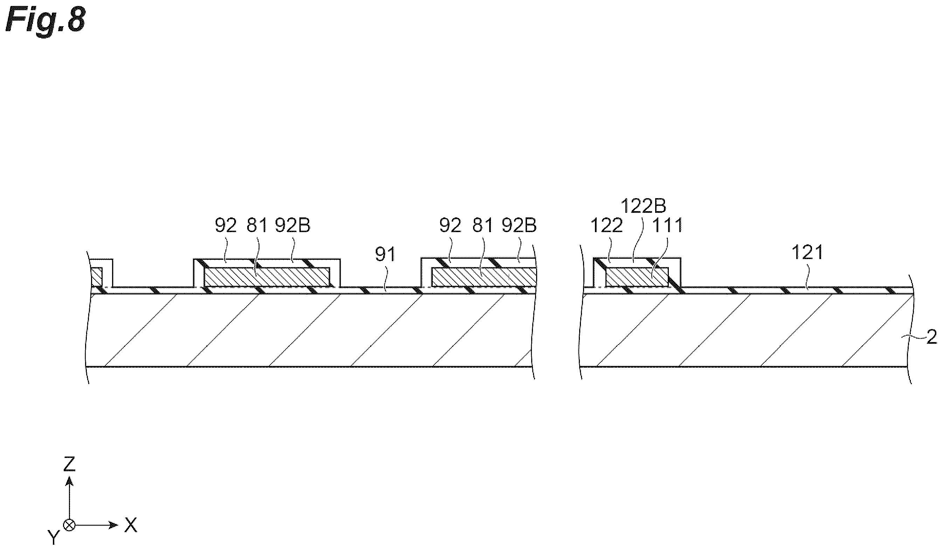

Subsequently, as illustrated in FIG. 8, the insulating layer 92 is formed on the first transfer electrode 81, and the insulating layer 122 is formed on the first capacitance electrode 111. In the present embodiment, the insulating layer 92 is formed to cover the entire first transfer electrode 81, and the insulating layer 122 is formed to cover the entire first capacitance electrode 111. The insulating layer 92 and the insulating layer 122 are simultaneously and integrally formed. The insulating layer 92 and the insulating layer 122 may be formed by performing an oxidation treatment on the surfaces of the first transfer electrode 81 and the first capacitance electrode 111. For example, in a case where the materials of the first transfer electrode 81 and the first capacitance electrode **111 are** polysilicon, the insulating layer 92 and the insulating layer 122 made of silicon oxide may be formed on the surfaces of the first transfer electrode 81 and the first capacitance electrode **111,** respectively, by the oxidation treatment.

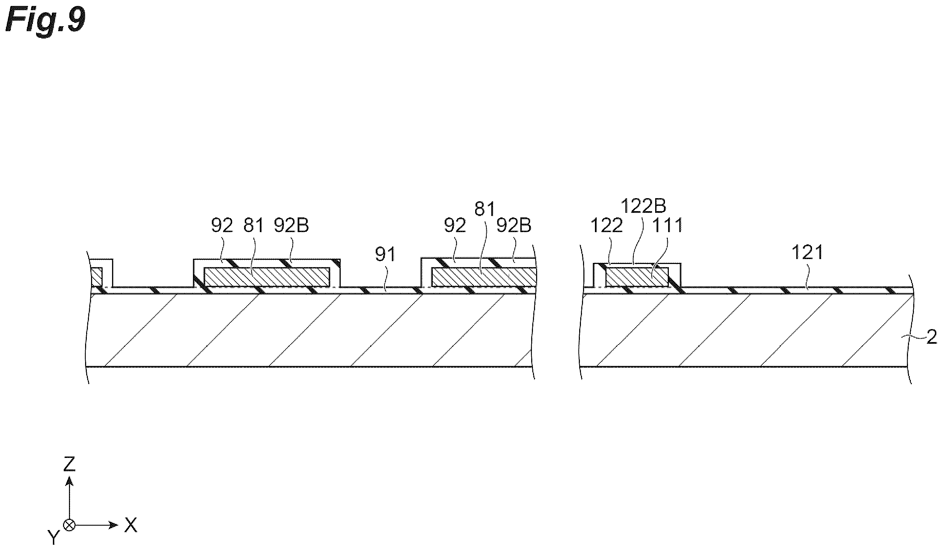

Subsequently, as illustrated in FIG. 9, a thickness of at least one of a portion 92B and a portion 122B is adjusted such that a thickness of the portion 92B of the insulating layer 92 positioned on the first transfer electrode 81 is larger than a thickness of the portion 122B of the insulating layer 122 positioned on the first capacitance electrode 111. In the present embodiment, the thickness of the portion 122B is reduced by performing the etching process on the insulating layer 122.

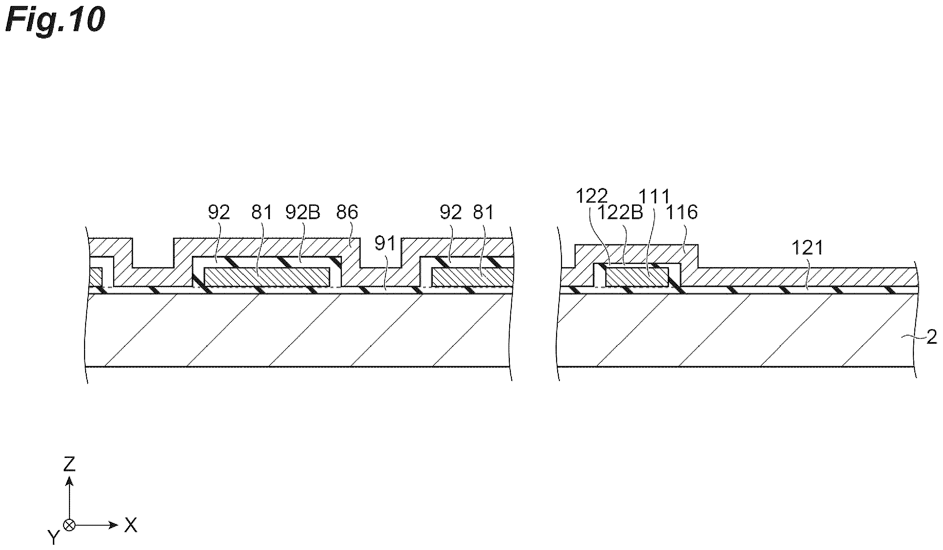

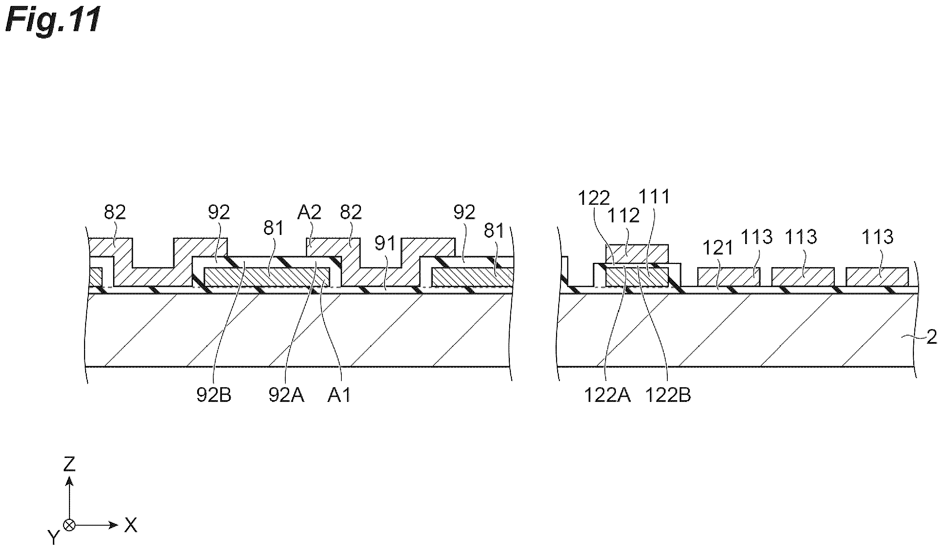

Subsequently, as illustrated in FIG. 10, an electrode layer 86 is formed on the surfaces of the insulating layers 91 and 92, and an electrode layer 116 is formed on surfaces of the insulating layers 121 and 122. The electrode layer 86 is made of a material of the second transfer electrode 82, and the electrode layer 116 is made of materials of the second capacitance electrode 112 and the electrode 113. The electrode layer 86 and the electrode layer 116 are simultaneously and integrally formed. Subsequently, as illustrated in FIG. **11****,** the etching process is performed on the electrode layer 86 and the electrode layer 116, and thus, the second transfer electrode 82, the second capacitance electrode 112, and the electrode 113 are formed. In a state where the second transfer electrode 82 is formed, a portion of the portion 92B positioned between the overlapping portion A1 of the first transfer electrode 81 and the overlapping portion A2 of the second transfer electrode 82 corresponds to the first portion 92A. In a state where the second capacitance electrode 112 is formed, the portion 122B corresponds to the second portion 122A. Subsequently, the solid-state imaging element 1 is obtained by further forming the plurality of insulating layers 90 on the second transfer electrode 82 and the insulating layer 92 and further forming the plurality of insulating layers 120 on the second capacitance electrode 112, the electrode 113, and the insulating layer 122.

As described above, in the solid-state imaging element 1, the overlapping portion A1 of the first transfer electrode 81 overlaps the overlapping portion A2 of the second transfer electrode 82 as viewed from the Z direction. As a result, it is less likely to form the gap between the first transfer electrode 81 and the second transfer electrode 82 as viewed from the Z direction. Thus, in the transfer part 32, the trapping of the charges can be suppressed, and the transfer of the charges can be appropriately performed. In addition, in the solid-state imaging element 1, the thickness T1 of the first portion 92A of the insulating layer 92 is larger than the thickness T2 of the second portion 122A of the insulating layer 122. As a result, the thickness T1 of the insulating layer positioned between the first transfer electrode 81 and the second transfer electrode 82 can be increased, and withstand voltage characteristics between the first transfer electrode 81 and the second transfer electrode 82 can be improved. As a result, a high voltage can be applied to the transfer part 32, and a saturation charge amount and charge transfer efficiency in the transfer part 32 can be improved. On the other hand, the thickness T2 of the insulating layer positioned between the first capacitance electrode 111 and the second capacitance electrode 112 can be reduced, and downsizing of the capacitance part 101 (downsizing of the mounting area) can be realized while maintaining a desired capacitance value. Specifically, since the interval between the first capacitance electrode 111 and the second capacitance electrode 112 is narrowed, an area of each of the first capacitance electrode 111 and the second capacitance electrode 112 can be reduced. As a result, a distance between the capacitance part 101 and another circuit part (for example, a MOSFET, resistor, or other capacitance part) can be increased, and an increase in parasitic capacitance or occurrence of crosstalk between the capacitance part 101 and another circuit part can be suppressed. Accordingly, according to the solid-state imaging element 1, high reliability can be secured.

In the solid-state imaging element 1, the insulating layer 92 is formed integrally with the insulating layer 122. According to this configuration, high reliability can be secured with a simpler structure.

In the solid-state imaging element 1, the thickness T1 of the first portion 92A of the insulating layer 92 may be twice or more the thickness T2 of the second portion 122A of the insulating layer 122. According to this configuration, the withstand voltage characteristics between the first transfer electrode 81 and the second transfer electrode 82 can be further improved. Thus, a higher voltage can be applied to the transfer part 32, and a saturation charge amount and charge transfer efficiency in the transfer part 32 can be further improved.

In the solid-state imaging element 1, the first element unit 3 includes the amplifier part 33 that converts the charge transferred by the transfer part 32 into the analog signal, and the second element unit 4 includes the conversion part 41 that converts the analog signal into the digital signal. According to this configuration, the charge transferred by the transfer part 32 can be converted into the digital signal that is not easily influenced by noise.

In the solid-state imaging element 1, the operating voltage of the first element unit 3 may be higher than the operating voltage of the second element unit 4. According to this configuration, the saturation charge amount and the charge transfer efficiency in the transfer part 32 can be improved.

According to the method for manufacturing the solid-state imaging element 1, the thickness of the portion 92B of the insulating layer 92 positioned on the first transfer electrode 81 is adjusted to be larger than the thickness of the portion 122B of the insulating layer 122 positioned on the first capacitance electrode 111. As a result, in the manufactured solid-state imaging element 1, the thickness T1 of the insulating layer positioned between the first transfer electrode 81 and the second transfer electrode 82 can be increased, and the withstand voltage characteristics between the first transfer electrode 81 and the second transfer electrode 82 can be improved. As a result, a high voltage can be applied to the transfer part 32, and a saturation charge amount and charge transfer efficiency in the transfer part 32 can be improved. On the other hand, the thickness T2 of the insulating layer positioned between the first capacitance electrode 111 and the second capacitance electrode 112 can be reduced, and the downsizing of the capacitance part 101 can be realized while maintaining a desired capacitance value. As a result, it is possible to increase the distance between the capacitance part 101 and another circuit part, and it is possible to suppress the increase in parasitic capacitance or the occurrence of the crosstalk between the capacitance part 101 and another circuit part. Accordingly, according to the method for manufacturing the solid-state imaging element 1, it is possible to obtain the solid-state imaging element 1 capable of securing high reliability.

In the method for manufacturing the solid-state imaging element 1, the insulating layer 92 and the insulating layer 122 are simultaneously and integrally formed. According to this configuration, since the insulating layer 92 and the insulating layer 122 are simultaneously and integrally formed, the manufacturing efficiency of the solid-state imaging element 1 can be improved.

In the method for manufacturing the solid-state imaging element 1, in a step of adjusting the thickness of at least one of the portion 92B of the insulating layer 92 and the portion 122B of the insulating layer 122, the thickness of the portion 122B of the insulating layer 122 is reduced by performing the etching process on the insulating layer 122. According to this configuration, the thickness of the portion 122B can be more reliably reduced by the etching process.

### [Modifications]

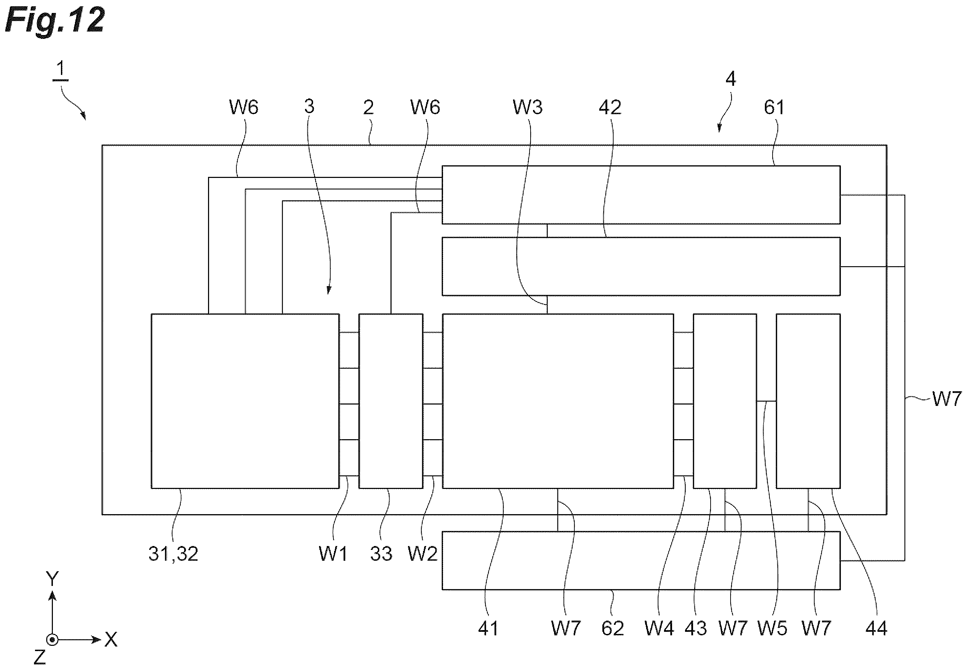

The present disclosure is not limited to the above embodiment. For example, as illustrated in FIG. 12, the second element unit 4 may include the generation part 61 that generates the drive signal for driving the first element unit 3. That is, in the modification illustrated in FIG. 12, the generation part 61 is formed inside the solid-state imaging element 1. The drive signal generated by the generation part 61 is transmitted to the first element unit 3. In the present modification, the second element unit 4 is configured to transmit the signal to the first element unit 3 and receive the signal from the first element unit 3. In the present modification, for example, first, the operating voltage is applied from the generation part 62 formed outside the solid-state imaging element 1 to the generation part 61 via the wiring W7. The operating voltage applied to the generation part 61 is boosted by the generation part 61 and is applied, as the operating voltage of the first element unit 3, to the first element unit 3 via the wiring W6. In the present modification, the capacitance part 101 may be formed in the generation part 61.

In the solid-state imaging element 1 according to the modification illustrated in FIG. 12, the second element unit 4 includes the generation part 61 that generates the drive signal for driving the first element unit 3. According to this configuration, since the drive signal for driving the first element unit 3 can be generated inside the solid-state imaging element 1, the voltage value of the drive signal supplied from the outside of the solid-state imaging element 1 to the first element unit 3 can be reduced.

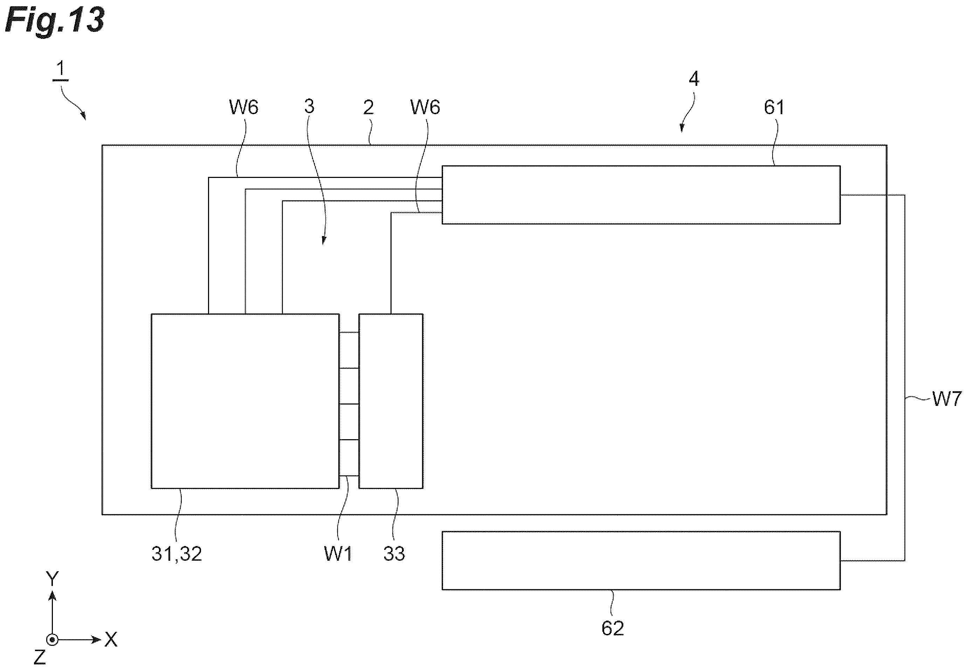

In addition, as illustrated in FIG. 13, the second element unit 4 may include only the generation part 61. The drive signal generated by the generation part 61 is transmitted to the first element unit 3. That is, in the present modification, the second element unit 4 is configured to transmit the signal to the first element unit 3. In the present modification, the capacitance part 101 is formed in the generation part 61. In this configuration, since the drive signal for driving the first element unit 3 can be generated inside the solid-state imaging element 1, the voltage value of the drive signal supplied from the outside of the solid-state imaging element 1 to the first element unit 3 can also be reduced. In addition, the configuration of the solid-state imaging element 1 can be further simplified. The second element unit 4 may be configured to perform at least one of transmission of a signal to the first element unit 3 and reception of a signal from the first element unit 3.

In the method for manufacturing the solid-state imaging element 1, in the step of adjusting the thickness of at least one of the portion 92B and the portion 122B, the thickness of the portion 92B may be increased by performing the film forming process on the insulating layer 92. According to this configuration, the thickness of the portion 92B can be more reliably increased by the film forming process.

The insulating layer 91 and the insulating layer 121 may be formed at different timings or may be formed separately. Similarly, the insulating layer 92 and the insulating layer 122 may be formed at different timings or may be formed separately. In addition, the electrode layer 85 and the electrode layer 115 may be formed at different timings, or may be formed separately. That is, a formation timing of the first transfer electrode 81 may be different from a formation timing of the first capacitance electrode 111. Similarly, the electrode layer 86 and the electrode layer 116 may be formed at different timings, or may be formed separately. That is, a formation timing of the second transfer electrode 82 may be different from a formation timing of the second capacitance electrode 112 and the electrode 113.

The thickness of the insulating layer 91 may be different from the thickness of the insulating layer 121. In addition, the thicknesses of the insulating layer 91 and the insulating layer 121 may not be uniform. For example, the thickness of the portion of the insulating layer 91 between the semiconductor layer 20 and the first transfer electrode 81 may be different from the thickness of the portion between the semiconductor layer 20 and the second transfer electrode 82. In addition, the thickness of the portion of the insulating layer 121 between the semiconductor layer 20 and the first capacitance electrode 111 may be different from the thickness of the portion between the semiconductor layer 20 and the electrode 113.

The second element unit 4 may have one capacitance part 101 or a plurality of capacitance parts 101. In a case where the second element unit 4 includes the plurality of capacitance parts 101, for example, each of the conversion part 41, the drive part 42, the multiplexer part 43, the output part 44, and the generation part 61 may include one or more capacitance parts 101.

The P-type and N-type conductivity types may be opposite to the conductivity types described above. For example, the semiconductor region 22 may have a P-type conductivity type, and the semiconductor region 23 may have a P⁺-type conductivity type. The "P⁺-type" means that a concentration of a P-type impurity is higher than that of the "P-type". The charge transfer method in the transfer part 32 is not limited to the two-phase driving method, and may be another method such as a three-phase driving method or a four-phase driving method.

The overlapping portion A2 of the second transfer electrode 82 may be positioned on the surface 81b side with respect to the first transfer electrode 81 in the Z direction. In this case, the second portion 84 of the second transfer electrode 82 is positioned to enter between the first transfer electrode 81 and the semiconductor layer 20. In this modification, in the manufacturing process of the solid-state imaging element 1, the first transfer electrode 81 is formed after the second transfer electrode 82 is formed.

In the above embodiment, a full frame transfer (FFT) method has been described as an example of the method for transferring the charges generated in the light receiving part 31, but the method for transferring the charges may be, for example, a frame transfer (FT) method, an inter-line (IT) method, or the like. In a case where the full frame transfer method or the frame transfer method is adopted as the charge transfer method, the region of the semiconductor layer 20 constituting the light receiving part 31 also functions as the transfer part 32. In contrast, in a case where the inter-line (IT) method is adopted as the charge transfer method, a region different from the region of the semiconductor layer 20 constituting the light receiving part 31 functions as the transfer part 32. In addition, in the above embodiment, the front-side incidence type solid-state imaging element 1 in which the light hv is incident from the wiring layer 50 side has been described as an example, but the solid-state imaging element 1 may be a back-side incidence type solid-state imaging element in which the light hv is incident from the surface 10b of the base portion 10. In the back-side incidence type solid-state imaging element 1, a portion of the base portion 10 immediately below the light receiving part 31 may be removed or thinned, and the light hv may be incident on the light receiving part 31 via the removed or thinned portion.

### Reference Signs List

- 1: solid-state imaging element
- 2: semiconductor substrate
- 3: first element unit
- 4: second element unit
- 31: light receiving part
- 32: transfer part
- 33: amplifier part
- 41: conversion part
- 61: generation part
- 81, 81A, 81B: first transfer electrode
- 82, 82A, 82B: second transfer electrode
- 92A: first portion
- 122A: second portion
- 92: insulating layer (first insulating layer)
- 92B, 122B: portion
- 101: capacitance part
- 111: first capacitance electrode
- 112: second capacitance electrode
- 122: insulating layer (second insulating layer)
- hv: light

## Claims

1. A solid-state imaging element comprising: a semiconductor substrate (2); a first element unit (3) formed on the semiconductor substrate; and a second element unit (4) formed on the semiconductor substrate, wherein the first element unit includes a light receiving part (31) configured to generate charges in response to incidence of light, and a transfer part (32) configured to transfer the charges, the second element unit is configured to perform at least one of transmission of a signal to the first element unit and reception of a signal from the first element unit, and includes at least one capacitance part, the transfer part (32) includes a first transfer electrode (81) and a second transfer (82) electrode that are aligned in a transfer direction of the charges, and a first insulating layer (92) configured to insulate the first transfer electrode and the second transfer electrode from each other, the at least one capacitance part (101) includes a first capacitance electrode (111)cand a second capacitance electrode (112) that overlap each other as viewed from a thickness direction of the semiconductor substrate, and a second insulating layer (122) configured to insulate the first capacitance electrode and the second capacitance electrode from each other, as viewed from the thickness direction of the semiconductor substrate, a part of the first transfer electrode overlaps a part of the second transfer electrode, the first insulating layer includes a first portion positioned between the part of the first transfer electrode and the part of the second transfer electrode, the second insulating layer includes a second portion positioned between the first capacitance electrode and the second capacitance electrode, and a thickness of the first portion of the first insulating layer is larger than a thickness of the second portion of the second insulating layer.

2. The solid-state imaging element according to claim 1, wherein the first insulating layer is formed integrally with the second insulating layer.

3. The solid-state imaging element according to claim 1 or 2, wherein the thickness of the first portion of the first insulating layer is twice or more the thickness of the second portion of the second insulating layer.

4. The solid-state imaging element according to any one of claims 1 to 3, wherein
the first element unit includes an amplifier part configured to convert the charge transferred by the transfer part into an analog signal, and
the second element unit includes a conversion part configured to convert the analog signal into a digital signal.

5. The solid-state imaging element according to any one of claims 1 to 4, wherein the second element unit includes a generation part configured to generate a drive signal for driving the first element unit.

6. The solid-state imaging element according to any one of claims 1 to 5, wherein an operating voltage of the first element unit is higher than an operating voltage of the second element unit.

7. A method for manufacturing the solid-state imaging element according to any one of claims 1 to 6, the method comprising:
a step of preparing the semiconductor substrate;
a step of forming the first transfer electrode and the first capacitance electrode on the semiconductor substrate;
a step of forming the first insulating layer on at least the first transfer electrode and forming the second insulating layer on at least the first capacitance electrode;
a step of adjusting a thickness of at least one of a portion of the first insulating layer positioned on the first transfer electrode and a portion of the second insulating layer positioned on the first capacitance electrode such that the thickness of the portion of the first insulating layer is larger than the thickness of the portion of the second insulating layer; and
a step of forming the second transfer electrode and the second capacitance electrode on the semiconductor substrate.

8. The method for manufacturing the solid-state imaging element according to claim 7, wherein in the step of forming the first insulating layer and forming the second insulating layer, the first insulating layer and the second insulating layer are simultaneously and integrally formed.

9. The method for manufacturing the solid-state imaging element according to claim 7 or 8, wherein in the step of adjusting the thickness of the at least one of the portion of the first insulating layer and the portion of the second insulating layer, the thickness of the portion of the second insulating layer is reduced by performing an etching process on the second insulating layer.

10. The method for manufacturing the solid-state imaging element according to any one of claims 7 to 9, wherein in the step of adjusting the thickness of the at least one of the portion of the first insulating layer and the portion of the second insulating layer, the thickness of the portion of the first insulating layer is increased by performing a film forming process on the first insulating layer.

## Patentansprüche

1. Festkörperbildgebungselement, umfassend: ein Halbleitersubstrat (2); eine erste Elementeinheit (3), die auf dem Halbleitersubstrat gebildet ist; und eine zweite Elementeinheit (4), die auf dem Halbleitersubstrat gebildet ist,
wobei die erste Elementeinheit ein Lichtempfangsteil (31) einschließt, das konfiguriert ist, als Reaktion auf Lichteinfall Ladungen zu erzeugen, und ein Transferteil (32), das konfiguriert ist, die Ladungen zu transferieren, die zweite Elementeinheit konfiguriert ist, mindestens eines von einer Übertragung eines Signals an die erste Elementeinheit und einem Empfang eines Signals von der ersten Elementeinheit auszuführen, und mindestens ein Kapazitätsteil einschließt, wobei das Transferteil (32) eine erste Transferelektrode (81) und eine zweite Transferelektrode (82) einschließt, die in einer Transferrichtung der Ladungen ausgerichtet sind, und
eine erste Isolierschicht (92), die konfiguriert ist, die erste Transferelektrode und die zweite Transferelektrode voneinander zu isolieren, wobei das mindestens eine Kapazitätsteil (101) eine erste Kapazitätselektrode (111) und eine zweite Kapazitätselektrode (112) einschließt, die sich von einer Dickenrichtung des Halbleitersubstrats aus betrachtet gegenseitig überlappen, und
eine zweite Isolierschicht (122), die konfiguriert ist, die erste Kapazitätselektrode und die zweite Kapazitätselektrode von der Dickenrichtung des Halbleitersubstrats aus betrachtet voneinander zu isolieren,
ein Teil der ersten Transferelektrode einen Teil der zweiten Transferelektrode überlappt, die erste Isolierschicht einen ersten Abschnitt einschließt, der zwischen dem Teil der ersten Transferelektrode und dem Teil der zweiten Transferelektrode positioniert ist, die zweite Isolierschicht einen zweiten Abschnitt einschließt, der zwischen der ersten Kapazitätselektrode und der zweiten Kapazitätselektrode positioniert ist, und eine Dicke des ersten Abschnitts der ersten Isolierschicht größer ist als eine Dicke des zweiten Abschnitts der zweiten Isolierschicht.

2. Festkörperbildgebungselement nach Anspruch 1, wobei die erste Isolierschicht mit der zweiten Isolierschicht integral gebildet ist.

3. Festkörperbildgebungselement nach Anspruch 1 oder 2, wobei die Dicke des ersten Abschnitts der ersten Isolierschicht das Zweifache oder mehr als die Dicke des zweiten Abschnitts der zweiten Isolierschicht beträgt.

4. Festkörperbildgebungselement nach einem der Ansprüche 1 bis 3, wobei
die erste Elementeinheit ein Verstärkerteil einschließt, das konfiguriert ist, die durch das Transferteil transferierte Ladung in ein analoges Signal umzuwandeln, und
die zweite Elementeinheit ein Umwandlungsteil einschließt, das konfiguriert ist, das analoge Signal in ein digitales Signal umzuwandeln.

5. Festkörperbildgebungselement nach einem der Ansprüche 1 bis 4, wobei die zweite Elementeinheit ein Erzeugungsteil einschließt, das konfiguriert ist, ein Ansteuersignal zum Antreiben der ersten Elementeinheit zu erzeugen.

6. Festkörperbildgebungselement nach einem der Ansprüche 1 bis 5, wobei eine Betriebsspannung der ersten Elementeinheit höher ist als eine Betriebsspannung der zweiten Elementeinheit.

7. Verfahren zur Herstellung des Festkörperbildgebungselements nach einem der Ansprüche 1 bis 6, wobei das Verfahren umfasst:
einen Schritt des Vorbereitens des Halbleitersubstrats;
einen Schritt des Bildens der ersten Transferelektrode und der ersten Kapazitätselektrode auf dem Halbleitersubstrat;
einen Schritt des Bildens der ersten Isolierschicht auf mindestens der ersten Transferelektrode und des Bildens der zweiten Isolierschicht auf mindestens der ersten Kapazitätselektrode;
einen Schritt des Einstellens einer Dicke von mindestens einem von einem Abschnitt der ersten Isolierschicht, der auf der ersten Transferelektrode positioniert ist, und einem Abschnitt der zweiten Isolierschicht, der auf der ersten Kapazitätselektrode positioniert ist, derart, dass die Dicke des Abschnitts der ersten Isolierschicht größer ist als die Dicke des Abschnitts der zweiten Isolierschicht; und
einen Schritt des Bildens der zweiten Transferelektrode und der zweiten Kapazitätselektrode auf dem Halbleitersubstrat.

8. Verfahren zur Herstellung des Festkörperbildgebungselements nach Anspruch 7, wobei in dem Schritt des Bildens der ersten Isolierschicht und des Bildens der zweiten Isolierschicht die erste Isolierschicht und die zweite Isolierschicht gleichzeitig und integral gebildet werden.

9. Verfahren zur Herstellung des Festkörperbildgebungselements nach Anspruch 7 oder 8, wobei in dem Schritt des Einstellens der Dicke von mindestens einem von dem Abschnitt der ersten Isolierschicht und dem Abschnitt der zweiten Isolierschicht die Dicke des Abschnitts der zweiten Isolierschicht durch Ausführen eines Ätzprozesses an der zweiten Isolierschicht verringert wird.

10. Verfahren zur Herstellung des Festkörperbildgebungselements nach einem der Ansprüche 7 bis 9, wobei in dem Schritt des Einstellens der Dicke von mindestens einem von dem Abschnitt der ersten Isolierschicht und dem Abschnitt der zweiten Isolierschicht die Dicke des Abschnitts der ersten Isolierschicht durch Ausführen eines Filmbildungsprozesses auf der ersten Isolierschicht vergrößert wird.

## Revendications

1. Élément d'imagerie à semi-conducteurs comprenant : un substrat semi-conducteur (2) ; une première section d'élément (3) formée sur le substrat semi-conducteur ; et une seconde section d'élément (4) formée sur le substrat semi-conducteur, dans lequel la première section d'élément inclut une unité de réception de lumière (31) configurée pour générer des charges en réponse à l'incidence de lumière, et une unité de transfert (32) configurée pour transférer les charges, la seconde section d'élément est configurée pour réaliser au moins une parmi une transmission d'un signal à la première section d'élément et la réception d'un signal provenant de la première section d'élément, et inclut au moins une unité de capacité, l'unité de transfert (32) inclut une première électrode de transfert (81) et une seconde électrode de transfert (82) qui sont alignées dans une direction de transfert des charges, et une première couche isolante (92) configurée pour isoler la première électrode de transfert et la seconde électrode de transfert l'une de l'autre, l'au moins une unité de capacité (101) inclut une première électrode de capacité (111) et une seconde électrode de capacité (112) qui se chevauchent l'une l'autre telles que vues depuis la direction d'épaisseur du substrat semi-conducteur, et une seconde couche isolante (122) configurée pour isoler la première électrode de capacité et la seconde électrode de capacité l'une de l'autre telles que vues depuis la direction d'épaisseur du substrat semi-conducteur, une partie de la première électrode de transfert chevauche une partie de la seconde électrode de transfert, la première couche isolante inclut une première partie positionnée entre la partie de la première électrode de transfert et la partie de la seconde électrode de transfert, la seconde couche isolante inclut une seconde partie positionnée entre la première électrode de capacité et la seconde électrode de capacité, et une épaisseur de la première partie de la première couche isolante est plus grande qu'une épaisseur de la seconde partie de la seconde couche isolante.

2. Élément d'imagerie à semi-conducteurs selon la revendication 1, dans lequel la première couche isolante est formée intégralement avec la seconde couche isolante.

3. Élément d'imagerie à semi-conducteurs selon la revendication 1 ou la revendication 2, dans lequel l'épaisseur de la première partie de la première couche isolante est deux fois ou plus l'épaisseur de la seconde partie de la seconde couche isolante.

4. Élément d'imagerie à semi-conducteurs selon l'une quelconque des revendications 1 à 3, dans lequel
la première section d'élément inclut une unité amplificatrice configurée pour convertir la charge transférée par l'unité de transfert en un signal analogique, et
la seconde section d'élément inclut une unité de conversion configurée pour convertir le signal analogique en un signal numérique.

5. Élément d'imagerie à semi-conducteurs selon l'une quelconque des revendications 1 à 4, dans lequel la seconde section d'élément inclut une unité de génération configurée pour générer un signal d'entraînement pour entraîner la première section d'élément.

6. Élément d'imagerie à semi-conducteurs selon l'une quelconque des revendications 1 à 5, dans lequel une tension de fonctionnement de la première section d'élément est supérieure à une tension de fonctionnement de la seconde section d'élément.

7. Procédé pour la fabrication de l'élément d'imagerie à semi-conducteurs selon l'une quelconque des revendications 1 à 6, le procédé comprenant :
une étape de préparation du substrat semi-conducteur ;
une étape de formation de la première électrode de transfert et la première électrode de capacité sur le substrat semi-conducteur ;
une étape de formation de la première couche isolante sur au moins la première électrode de transfert et de formation de la seconde couche isolante sur au moins la première électrode de capacité ;
une étape d'ajustement d'une épaisseur d'au moins une parmi une partie de la première couche isolante positionnée sur la première électrode de transfert et une partie de la seconde couche isolante positionnée sur la première électrode de capacité de sorte que l'épaisseur de la partie de la première couche isolante soit plus grande que l'épaisseur de la partie de la seconde couche isolante ; et
une étape de formation de la seconde électrode de transfert et de la seconde électrode de capacité sur le substrat semi-conducteur.

8. Procédé de fabrication de l'élément d'imagerie à semi-conducteurs selon la revendication 7, dans lequel, dans l'étape de formation de la première couche isolante et de formation de la seconde couche isolante, la première couche isolante et la seconde couche isolante sont formées simultanément et intégralement.

9. Procédé de fabrication de l'élément d'imagerie à semi-conducteurs selon la revendication 7 ou la revendication 8, dans lequel, dans l'étape d'ajustement de l'épaisseur de l'au moins une parmi la partie de la première couche isolante et la partie de la seconde couche isolante, l'épaisseur de la partie de la seconde couche isolante est réduite par la réalisation d'un procédé de gravure sur la seconde couche isolante.

10. Procédé de fabrication de l'élément d'imagerie à semi-conducteurs selon l'une quelconque des revendications 7 à 9, dans lequel, dans l'étape d'ajustement de l'épaisseur de l'au moins une parmi la partie de la première couche isolante et la partie de la seconde couche isolante, l'épaisseur de la partie de la première couche isolante est augmentée par la réalisation d'un procédé de formation de film sur la première couche isolante.
